# EUROPEAN PATENT APPLICATION

(11) **EP 2 068 371 A2**
(43) Date of publication of application: **10.06.2009**
(21) Application number: 08075922.8
(22) Date of filing: 05.12.2008
(51) Int. Cl.: H01L 31/04

(54) **Solar panel curtain**

(30) Priority: 07.12.2007 TW 96146789
(71) Applicant: Advanced-Connected Inc., Hsin-Tien, Taipei Hsien (TW)
(72) Inventor: Chien, Wen-Hsiang, Hsin Tien, Taipei (TW); Lin, Hsiu-Tung, Hsin Tien, Taipei (TW); Lin, Wen-Chin, Hsin Tien, Taipei (TW)
(74) Representative: Arth, Hans-Lothar

(57) **Abstract**

A solar panel curtain including a plurality of sunshield panels disposed in parallel, an electric energy storage device electrically connected to the sunshield panels, an orientation device connected to the sunshield panels and electrically connected to the electric energy storage device, and a switch device is provided. Each sunshield panel includes plural solar panels locked to each other. The electric energy storage device receives and stores the electric energy generated by the sunshield panels. The orientation device orients the sunshield panels, wherein power is supplied to the orientation device by the electric energy storage device or an external power source. The switch device is electrically connected to the orientation device for turning on or off the orientation device. The solar panel curtain may further include a photo detector device and a knob device such that the sunshield panels can be either automatically oriented or manually operated through the knob device.

## Description

### BACKGROUND OF THE INVENTION

### 1. Field of the Invention

The present invention generally relates to a solar panel curtain, and more particularly, to a curtain constituted by a plurality of solar panels which are connected to each other lengthwise or widthwise and are automatically or manually oriented toward a light source to generate electric energy.

### 2. Description of Related Art

Many houses or office buildings are installed with outward windows allowing more sunlight to come in. However, the increasing sunlight may cause furniture to fade or damage electronic appliances. Accordingly, economic loss may be caused if the curtains are left open.

Additionally, along with the increase in the prices of energy sources, renewable energy sources (including solar energy and wind energy, etc) have been gradually brought into the spotlight as low-cost substitute energy sources. Solar panels are usually installed on rooftops or at unshaded places in order to receive more sunlight and accordingly generate more electric energy. However, regarding a high-rise building, the limited rooftop space thereof cannot meet the requirement of all the residents live in the building. However, since every unit in the building comes with outward windows, how to fully utilize these windows and the sunlight passing through these windows is to he resolved.

### SUMMARY OF THE INVENTION

Accordingly, the present invention is directed to a solar panel curtain, wherein solar panels are directly served as sunshield panels so that electric energy is generated while the sunlight is shielded.

The present invention is directed to a solar panel curtain which automatically orients front surfaces of sunshield panels toward the sunlight so that electric energy is generated while the sunlight is shielded.

The present invention provides a solar panel curtain including a plurality of sunshied panels disposed in parallel, an electric energy storage device electrically connected to the sunshield panels, an orientation device connected to the sunshield panels and electrically connected to the electric energy storage device, and a switch device.

Each of the sunshield panels is a solar photoelectric panel including a plurality of solar panels, wherein each of the solar panels is approximately rectangular and has a first side, a second side, a front surface, and a back surface, the first side of one solar panel may be locked to the second side of another solar panel, and the front surfaces of all the solar panels face the same direction.

The electric energy storage device is electrically connected to the sunshield panels and includes a voltage regulation device and a storage battery. The voltage regulation device regulates the electric energy generated by the sunshield panels. The storage battery is connected to the voltage regulation device and receives and stores the electric energy regulated by the voltage regulation device.

The orientation device is connected to the sunshield panels and orients the sunshield panels, and the orientation device is electrically connected to the electric energy storage device.

The switch device is electrically connected to the orientation device and turns on or off the orientation device. The switch device can be switched to a first position or a second position. When the switch device is switched to the first position, the orientation device is turned on and orients the sunshield panels, and when the switch device is switched to the second position, the orientation device is turned off.

According to an embodiment of the present invention, the switch device is further electrically connected to a photo detector device. When the switch device is switched to the first position and the photo detector device is irradiated by the sunlight, the orientation device is automatically turned on and orients the front surfaces of the solar panels toward the sunlight. When the switch device is switched to the first position and the photo detector device is not irradiated by the sunlight, the orientation device is turned on and orients the solar panels so that the front surface of each solar panel faces the back surface of the adjacent solar panel.

According to an embodiment of the present invention, the orientation device is further connected to a knob device. When the switch device is switched to the second position, the orientation device can be manually operated through the knob device to orient the solar panels.

According to an embodiment of the present invention, the solar panels of the sunshield panels may be locked to each other lengthwise or widthwise.

According to an embodiment of the present invention, the solar panels are single crystal solar panels.

According to an embodiment of the present invention, the solar panels are poly silicon solar panels.

According to an embodiment of the present invention, the solar panels are amorphous silicon solar panels.

According to an embodiment of the present invention, the solar panels are thin film solar panels.

According to an embodiment of the present invention, the solar panels are dye-sensitized solar panels. According to the characteristics of a dye-sensitized solar panel, the substrate thereof is not made of any silicon semiconductor material; instead, TiO2 nanometer particles are coated on a substrate having a conductive film, the substrate is sintered at 450°C to obtain a semiconductor photoelectrode, and platinum evaporation is performed to the transparent conductive film to form the opposite electrode.

According to an embodiment of the present invention, the solar panels are flexible solar panels.

The present invention further provides a solar panel curtain including a plurality of sunshield panels disposed in parallel, an electric energy storage device electrically connected to the sunshield panels, a scroll device connected to the sunshield panels and electrically connected to the electric energy storage device, and a switch device.

Each of the sunshield panels includes a plurality of solar panels, wherein each of the solar panels is approximately rectangular and has a first side, a second side, a front surface, and a back surface, the first side of one solar panel may be locked to the second side of another solar panel, and the front surfaces of all the solar panels face the same direction.

The electric energy storage device is electrically connected to the sunshield panels and includes a voltage regulation device and a storage battery. The voltage regulation device regulates the electric energy generated by the sunshield panels. The storage battery is connected to the voltage regulation device and receives and stores the electric energy regulated by the voltage regulation device.

The scroll device is electrically connected to the electric energy storage device and controls the sunshield panels to move lengthwise so as to collapse or expand the solar panel curtain.

The switch device is electrically connected to the scroll device and turns on or off the scroll device. The switch device can be switched to a first position or a second position. When the switch device is switched to the first position, the scroll device is turned on and moves the sunshield panels lengthwise so as to collapse or expand the solar panel curtain, and when the switch device is switched to the second position, the scroll device is turned off.

According to an embodiment of the present invention, the switch device is further electrically connected to a photo detector device. When the switch device is switched to the first position and the photo detector device is irradiated by the sunlight, the scroll device is automatically turned on and expands the solar panels to orient the front surfaces of the solar panels toward the sunlight. When the switch device is switched to the first position and the photo detector device is not irradiated by the sunlight, the scroll device is turned on and collapses the solar panels so that the inside of the room can be exposed through the windows.

According to an embodiment of the present invention, the scroll device is further connected to a pull cord. When the switch device is switched to the second position, the scroll device can be manually operated through the pull cord so as to expand or collapse the sunshield panels.

According to an embodiment of the present invention, the solar panels of the sunshield panels are locked to each other lengthwise or widthwise.

According to an embodiment of the present invention, the solar panels are flexible solar panels.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1 is a front view of a solar panel curtain according to a first embodiment of the present invention, wherein solar panels of the solar panel curtain are locked to each other lengthwise.

FIG. 2A is a front view of a solar panel in a solar panel curtain according to the present invention.

FIG. 2B is a side view of a solar panel in a solar panel curtain according to the present invention.

FIG. 3 is a front view of the solar panel in FIG. 1 turned 90°.

FIG. 4 is a front view of a solar panel curtain further including a photo detector device according to the present invention.

FIG. 5A is a front view of the solar panel curtain according to the first embodiment of the present invention, wherein the solar panels of the solar panel curtain are locked to each other widthwise.

FIG. 5B is a front view of the solar panels in FIG. 5A turned 90°.

FIG. 6 is a front view of a solar panel curtain according to a second embodiment of the present invention, wherein solar panels of the solar panel curtain are locked to each other widthwise.

FIG. 7 is a front view of the solar panel curtain in FIG. 6 collapsed upwardly.

FIG. 8 is a front view of the solar panel curtain according to the second embodiment of the present invention, wherein the solar panels of the solar panel curtain are locked to each other lengthwise.

### DESCRIPTION OF THE EMBODIMENTS

Reference will now be made in detail to the present preferred embodiments of the invention, examples of which are illustrated in the accompanying drawings. Wherever possible, the same reference numbers are used in the drawings and the description to refer to the same or like parts.

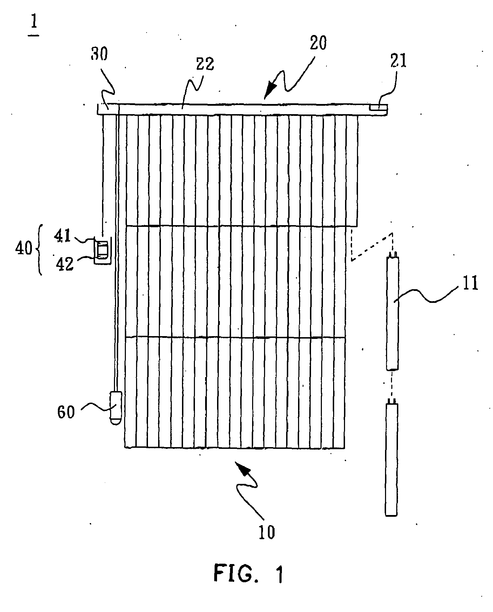

FIG. 1 is a front view of a solar panel curtain 1 according to a first embodiment of the present invention. Referring to FIG. 1, the solar panel curtain 1 includes a plurality of sunshield panels 10 disposed in parallel, an electric energy storage device 20 electrically connected to the sunshield panels 10, an orientation device 30 connected to the sunshield panels 10 and electrically connected to the electric energy storage device 20, and a switch device 40 electrically connected to the orientation device 30.

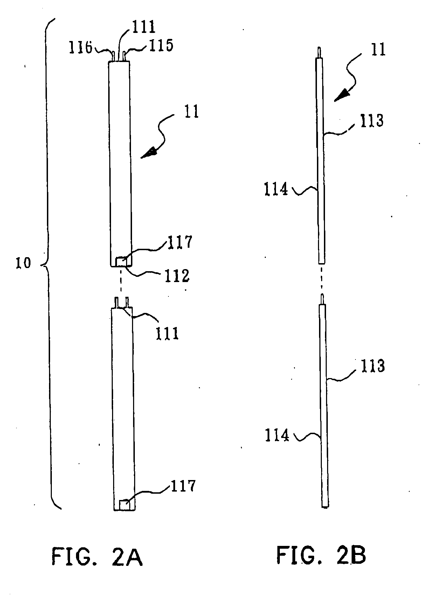

Referring to FIGs. 1, 2A, and 2B, each of the sunshield panels 10 includes a plurality of solar panels 11. Each of the solar panels 11 is approximately rectangular and has a first side 111, a second side 112, a front surface 113, and a back surface 114, and the solar panel 11 has two electrodes 115 and 116 at the first side 111 thereof for transmitting electric signals. The first side 111 of one solar panel 11 is locked to the second side 112 of another solar panel 11, and the front surfaces 113 of all the solar panels 11 face the same direction. The front surfaces 113 of all the solar panels 11 I have to face the sunlight in order to allow the solar panels 11 to generate electric energy. Because each of the solar panels 11 individually forms an electric loop, the electric loop can be turned off through a switch 117, and a series connection is obtained when the solar panel 11 is locked to other solar panels 11, wherein the switch 117 may be a knob which is turned by a solid plate to turn on or off the electric loop.

Referring to FIG. 1, the electric energy storage device 20 is connected to the sunshield panels 10 and includes a voltage regulation device 21 and a storage battery 22. The voltage regulation device 21 regulates the electric energy generated by the sunshield panels 10, and the storage battery 22 receives and stores the electric energy regulated by the voltage regulation device 21.

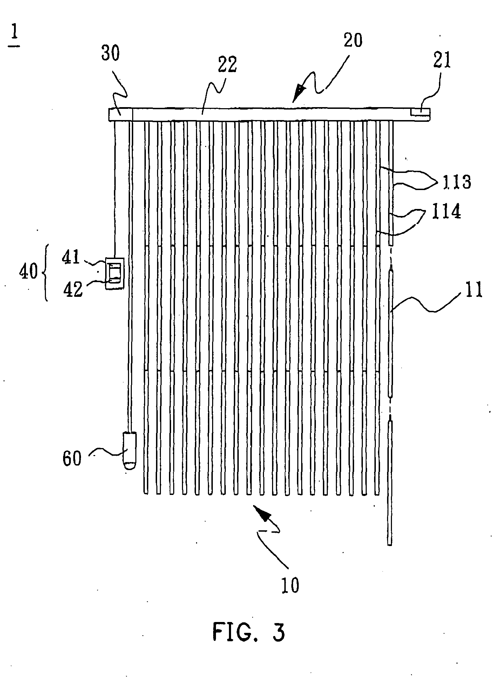

Referring to FIG. 1, the orientation device 30 orients the sunshield panels 10 and is electrically connected to the electric energy storage device 20. The orientation device 30 can turn the sunshield panels 10 for 90°. Referring to FIG. 3, the orientation device 30 can turn the front surfaces 113 of all the solar panels 11 of all the sunshield panels 10 away from the sunlight for 90°. The orientation device 30 may be implemented by using a motor, gears, racks, or belts.

In order to prevent the power from going off and accordingly not be able to turning on the orientation device 30, the electric energy storage device 20 is further electrically connected to an external power supply (not shown) as a backup power source, so as to maintain the normal operation of the solar panel curtain 1.

Referring to FIG. 1, the switch device 40 is electrically connected to the orientation device 30 for turning on or off the orientation device 30. The switch device 40 can be switched to a first position 41 or a second position 42. When the switch device 40 is switched to the first position 41, the orientation device 30 is turned on to orient the sunshield panels 10. When the switch device 40 is switched to the second position 42, the orientation device 30 is turned off.

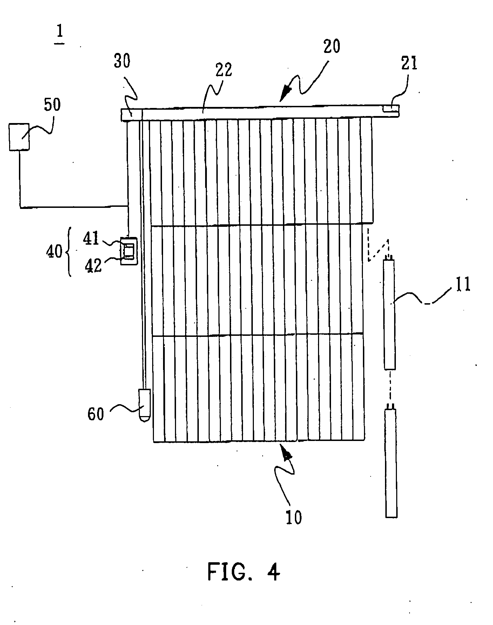

Referring to FIG. 4, in the present embodiment, the switch device 40 is further electrically connected to a photo detector device 50. The photo detector device 50 may be disposed either indoors or outdoors as long as sunlight can be received.

When the photo detector device 50 detects the sunlight and the switch device 40 is switched to the first position 41, the orientation device 30 is automatically turned on and orients the front surfaces 113 of all the solar panels 11 toward the sunlight. When the photo detector device 50 does not detect the sunlight and the switch device 40 is switched to the first position 41, the orientation device 30 is automatically turned on and orients the front surface 113 of each solar panel 11 toward the back surface 114 of the adjacent solar panel 11. If the switch device 40 is switched to the second position 42, the orientation device 30 is not automatically turned on; instead, the orientation of the front surfaces 113 of the solar panels 11 has to be adjusted manually. In this case, the orientation device 30 is further connected to a knob device 60. When the switch device 40 is switched to the second position 42, the orientation device 30 can be manually operated through the knob device 60 to adjust the orientation of the solar panels 11.

In the present embodiment, the solar panels 11 may be single crystal solar panels, poly silicon solar panels, amorphous silicon solar panels, thin film solar panels, dye-sensitized solar panels, or flexible solar panels.

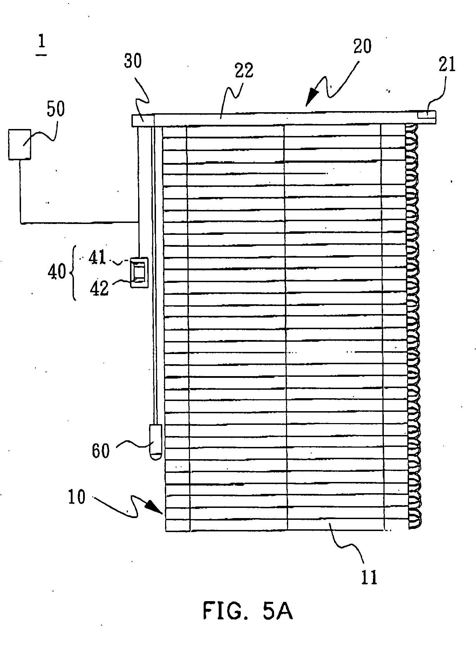

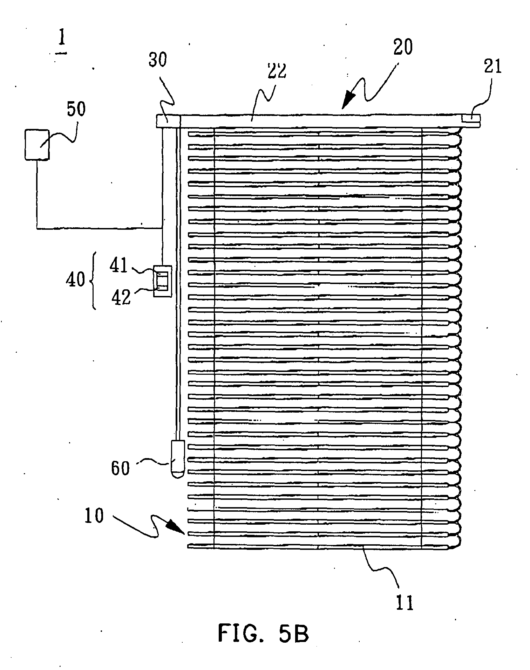

. Referring to FIG. 1, in the present embodiment, the solar panels 11 of the sunshield panels 10 are locked to each other lengthwise. Referring to FIG. 5A, the solar panels 11 of the sunshield panels 10 are locked to each other widthwise. In the latter case, the sunshield panels 10 may be connected by several solar panels 11 locked to each other widthwise so that the electrodes 115 and 116 of the solar panels 11 at the side can be exposed and electrically connected to the electric energy storage device 20. Referring to FIGs. 5A and 5B, in the present embodiment, the electrodes 115 and 116 are exposed at the right side and may be connected in series or parallel. Regardless of whether the solar panels 11 are lucked to each other lengthwise or widthwise, it is a series connection when the electrode 115 of a solar panel 11 is locked to the electrode 116 of the adjacent solar panel 11, and it is a parallel connection when the electrode 115 of a solar panel 11 is locked to the electrode 115 of the adjacent two solar panel 11.

As described above, the switch device 40 may be further electrically connected to a photo detector device 50 and the orientation device 30 may be further connected to a knob device 60 so that the solar panel curtain 1 can be operated either manually or automatically; however, the implementation of such a solar panel curtain 1 will not be described herein.

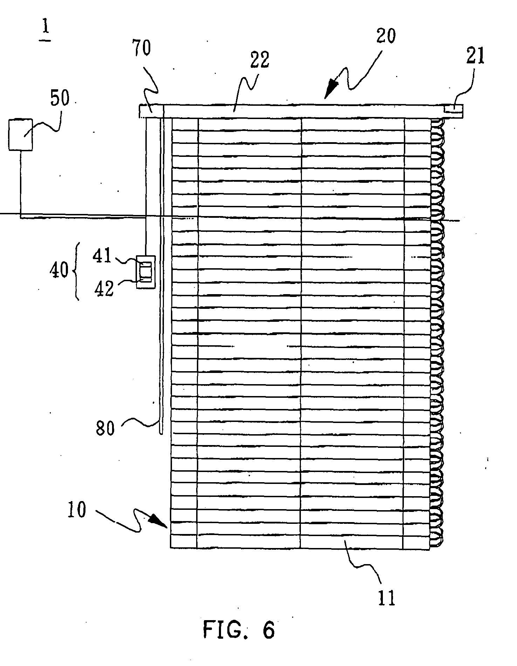

FIG. 6 is a view showing the solar panel curtain 1 according to a second embodiment of the present invention. Referring to FIG. 6, the solar panel curtain 1 includes a plurality of sunshield panels 10 disposed in parallel, an electric energy storage device 2 electrically connected to the sunshield panels 10, a scroll device 70 which controls the sunshield panels 10 to move lengthwise and is electrically connected to the electric energy storage device 20, and a switch device 40 electrically connected to the scroll device 70. The sunshield panels 10, the electric energy storage device 20, and the switch device 40 are the same as those described in the first embodiment, and the only difference between the first and the second embodiment is that the sunshield panels 10 in the second embodiment are flexible solar panels (will be described in detail below). The switch device 40 is electrically connected to the scroll device 70 for turning on or off the scroll device 70. The switch device 40 can be switched to a first position 41 or a second position 42. When the switch device 40 is switched to the first position 41, the scroll device 70 is turned on to move the sunshield panels 10 lengthwise, so as to collapse or expand the sunshield panels 10 of the solar panel curtain 1. When the switch device 40 is switched to the second position 42, the scroll device 70 is turned off.

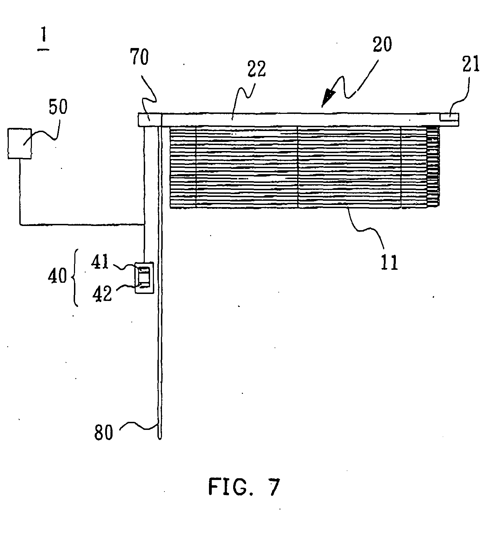

Referring to FIGs. 6 and 7, in the present embodiment, the switch device 40 is further electrically connected to a photo detector device 50. When the switch device 40 is switched to the first position 41 and the photo detector device 50 is irradiated by the sunlight, the scroll device 70 is automatically turned on to expand the sunshield panels 10 and orient the front surfaces 113 of the solar panels 11 toward the sunlight. If the switch device 40 is switched to the first position 41 but the photo detector device 50 is not irradiated by the sunlight, the scroll device 70 is turned on to collapse the sunshield panels 10, so that the inside of the room can be exposed through the windows.

Referring to FIGs. 6 and 7, in the present embodiment, the scroll device 70 is further connected to a pull cord 80. When the switch device 40 is switched to the second position 42, the scroll device 70 can be manually operated through the pull cord 80 to expand or collapse the sunshield panels 10.

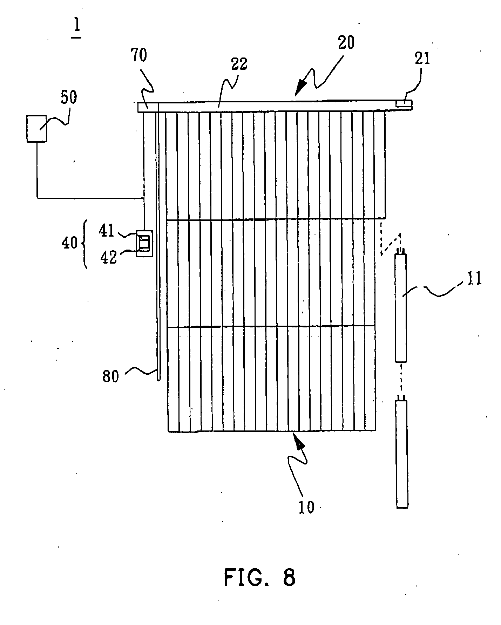

Referring to FIG. 7, in the present embodiment, the solar panels 11 of the sunshield panels 10 are locked to each other widthwise. Referring to FIG. 8, the solar panels 11 of the sunshield panels 10 are locked to each other lengthwise. Because the sunshield panels 10 are constituted by flexible solar panels, the sunshield panels 10 can always be folded or rolled upwards without affecting the function of the sunshield panels 10 regardless of whether the solar panels are locked to each other lengthwise or widthwise. Referring to FIG. 7, in the present embodiment, the solar panels 11 of the sunshield panels 10 are locked to each other widthwise, and the sunshield panels 10 are folded upwards.

The connection of the electrodes 115 and 116 between adjacent solar panels 11 has been described above therefore will not be described herein.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A solar panel curtain, comprising:
a plurality of sunshield panels disposed in parallel, wherein each of the sunshield panels comprises a plurality of solar panels, each of the solar panels is approximately rectangular and has a first side, a second side, a front surface, and a back surface, the first side of one of the solar panels is locked to the second side of another one of the solar panels, and all the front surfaces face a same direction;
an electric energy storage device, electrically connected to the sunshield panels, the electric energy storage device comprising a voltage regulation device and a storage battery, wherein the voltage regulation device regulates an electric energy energy generate by the sunshield panels, and the storage battery is connected to the voltage regulation device for receiving and storing the electric energy regulated by the voltage regulation device;
an orientation device, connected to the sunshield panels for orienting the sunshield panels, and electrically connected to the electric energy storage device; and
a switch device, electrically connected to the orientation device for turning on or off the orientation device, wherein the switch device can be switched to a first position or a second position, when the switch device is switched to the first position, the orientation device is turned on to orient the sunshield panels, and when the switch device is switched to the second position, the orientation device is turned off.

2. The solar panel curtain according to claim 1, wherein the switch device is further electrically connected to a photo detector device, and when the switch device is switched to the first position and the photo detector device is irradiated by a sunlight, the orientation device is automatically turned on to orient the front surfaces of all the solar panels toward the sunlight.

3. The solar panel curtain according to claim 2, wherein when the photo detector device does not detect the sunlight, the orientation device is turned on to orient the front surface of each of the solar panels toward the back surface of the adj acent solar panel.

4. The solar panel curtain according to claim 1, wherein the orientation device is further connected to a knob device, and the orientation device can be manually operated through the knob device when the switch device is switched to the second position.

5. The solar panel curtain according to claim 1, wherein the solar panels of the sunshield panels are locked to each other lengthwise.

6. The solar panel curtain according to claim 1, wherein the solar panels of the sunshield panels are locked to each other widthwise.

7. The solar panel curtain according to claim 1, wherein the solar panels are single crystal solar panels.

8. The solar panel curtain according to claim 1, wherein the solar panels are poly silicon solar panels.

9. The solar panel curtain according to claim 1, wherein the solar panels are amorphous silicon solar panels.

10. The solar panel curtain according to claim 1, wherein the solar panels are thin film solar panels.

11. The solar panel curtain according to claim 1, wherein the solar panels are dye-sensitized solar panels.

12. The solar panel curtain according to claim 1, wherein the solar panels are flexible solar panels.

13. A solar panel curtain, comprising:
a plurality of sunshield panels disposed in parallel, wherein each of the sunshield panels comprises a plurality of solar panels, each of the solar panels is approximately rectangular and has a first side, a second side, a front surface, and a back surface, the first side of one of the solar panels is locked to the second side of another one of the solar panels, and all the front surfaces face a same direction;
an electric energy storage device, electrically connected to the sunshield panels, the electric energy storage device comprising a voltage regulation device and a storage battery, wherein the voltage regulation device regulates an electric energy generated by the sunshield panels, and the storage battery is connected to the voltage regulation device for receiving and storing the electric energy regulated by the voltage regulation device;
a scroll device, connected to the sunshield panels for controlling the sunshield panels to move lengthwise, and electrically connected to the electric energy storage device; and
a switch device, electrically connected to the scroll device for turning on or off the scroll device, wherein the switch device can be switched to a first position or a second position, when the switch device is switched to the first position, the scroll device is turned on to move the sunshield panels lengthwise, so as to collapse or expand the solar panel curtain, and when the switch device is switch to the second position, the scroll device is turned off.

14. The solar panel curtain according to claim 13, wherein the switch device is further electrically connected to a photo detector device, and when the switch device is switched to the first position and the photo detector device is irradiated by a sunlight, the scroll device is automatically turned on to expand the solar panels and orient the front surfaces toward the sunlight.

15. The solar panel curtain according to claim 14, wherein when the photo detector device is not irradiated by the sunlight, the scroll device is turned on to collapse the solar panels.

16. The solar panel curtain according to claim 13, wherein the scroll device is further connected to a pull cord, and the scroll device can be manually operated through the pull cord when the switch device is switched to the second position.

17. The solar panel curtain according to claim 13, wherein the solar panels of the sunshield panels are locked to each other lengthwise.

18. The solar panel curtain according to claim 13, wherein the solar panels of the sunshield panels are locked to each other widthwise.

19. The solar panel curtain according to claim 13, wherein the solar panels are flexible solar panels.
